# EUROPEAN PATENT SPECIFICATION

(11) **EP 0 491 499 B1**
(45) Date of publication and mention of the grant of the patent: **12.06.1996**
(21) Application number: 91311243.9
(22) Date of filing: 03.12.1991
(51) Int. Cl.: H03K 17/60, H03K 17/64, H02M 7/515, H02M 7/5387

(54) **Drive circuit**
Treiberschaltung
Circuit de commande

(30) Priority: 19.12.1990 GB 9027545
(43) Date of publication of application: 24.06.1992
(73) Proprietor: THORN LIGHTING LIMITED, Borehamwood, Hertfordshire WD6 1HZ (GB)
(72) Inventor: Vos, Raymond Arthur, Chesnut, Hertfordshire EN8 0TP (GB)
(74) Representative: Fleming, Ian Alexander, Dr.

(56) References cited:
- US-A- 3 770 986
- US-A- 3 983 321
- US-A- 4 447 741
- IEEE APEC'88 CONFERENCE PROCEEDINGS February 1988, NEW ORLEANS US pages 360 - 366; J.G.HAYES ET AL.: 'Zero-voltage switching in a constant frequency digitally controlled resonant DC-DC power converter'
- EP-A 0291 742
- S.W. Amos, "Principles of transistor circuits", Ilife Books Ltd, 3rd edition 1965, page 230
- J. Markus, "Sourcebook of Electronic Circuits", McGraw Hill Book Company, page 235, circuit "SELF-EXCITED HALF-BRIDGE"

## Description

The present invention relates to a drive circuit in combination with a bridge circuit having a net load across its output, the net load being inductive at the operating frequency, this arrangement being typical in many switch mode power supply applications.

The basic principles for switching such bridge configurations are well known. For example in Figure 1 a half bridge configuration is shown where reverse diodes D1 and D2 are shown connected across a series arrangement of switches S1 and S2. The switches S1 and S2 may, for example, be a pair of MOSFETS. Cp1 and Cp2 represent capacitance existing between a switching point Vs and two DC voltage supply rails Vhi and Vlo. During operation of such circuit only one of the switches S1 and S2 will be turned on at any time so as to avoid any crowbar current flowing directly from Vhi to Vlo via the switches S1 and S2 only.

By way of example consider a current I flowing from a load L via the turned on switch S1 as shown in Figure 2 where Vs ≈ Vlo. If S1 is turned off at time t1 I will continue to flow charging the capacitances Cp1 and Cp2 until Vs ≈Vhi at time t2 and as shown in Figure 3 the load current will now flow via D2. Figure 4 shows how the voltage Vs changes during this switching period. In this example the current I will eventually fall to zero at time t3 by which time S2 should be turned on in order to allow current to build on the reverse direction as shown in Figure 5. When S2 is turned off the reverse action to that described above occurs.

Bridge circuits similar to that described above can be made to operate with low switching losses provided the switch turn off speed is fast and the turn on time is between t2 and t3.

Various techniques to control the switching of bridge configurations exist and can generally be assessed under four headings namely flexibility eg: variable pulse width or frequency, efficiency, component cost and control circuit power requirements.

Specific technical difficulties relate to the implementation of such circuits. In many applications the bridge will operate across a high voltage DC rail (typically 50V to peak mains voltages and above, 500V+) which results in large commutating voltages between the switch control terminals generating high dv/dt values. The large voltages require the use of either an isolation barrier or a high voltage level shifting technique. Isolation often causes propagation delays and slow switching speeds. Level shifting is adversely affected by the large dv/dt of the commutating voltage.

Generally, for inductive circuits, we have found that for idealised drive characteristics the turn on speed is not a difficult design problem provided that switching occurs between t2 and t3 as described earlier. The peak current drive required is quite low and can be provided from a voltage source using a series resistance current limit which works with, for example, the gate capacitance of a MOSFET in order to provide the relevant time constant. One design difficulty is providing an isolated drive to the high side switch S2 and, a second difficulty is that energy must be provided in order to charge the gate capacitance.

In contrast to the turn on requirement, we have found that for idealised drive characteristics the turn off speed needs to be very fast which requires drawing high peak currents from the gate terminal. In many designs this discharge current flows via the primary of a transformer coupling in which case a very low leakage reactance is required. There is no essential requirement that the control circuit should provide significant drive current in order to discharge the gate terminal.

An object of the present invention is to provide a drive circuit for a bridge circuit of a design which strives to overcome the technical difficulties associated with prior art arrangements and to strive to provide a low cost drive circuit exhibiting the idealised drive characteristics described above with a low control circuit supply current requirement.

Accordingly the present invention provides a drive circuit in combination with a bridge circuit, said bridge circuit having a net load coupled to its output, the net load being inductive at the operating frequency, the combination of drive circuit and bridge circuit including a series circuit of first and second switching elements coupled between first and second DC voltage supply lines said switching elements having respective secondary feedback windings for the inductive load, and switching means for alternatively switching on and off said first and second switching elements, characterised in that said switching means comprises first and second switching devices each coupled to an associated one of said switching elements and synchronising means to energise the switching devices at predetermined intervals, the arrangement being such energising the switching device associated with whichever switching element is ON switches that element OFF and that switching said switching element OFF causes, by virtue of the net load being inductive, a commutating voltage which is employed to turn ON said other switching element.

In one embodiment at least one of the switching devices is connected directly across the switching control terminals of its associated switching element, the switching device being activated by a lower power signal in order to apply a low impedance direct discharge of the switching terminals.

Advantageously circuit means is provided whereby the energy used to turn on the switching elements is derived directly from the net load such that the total energy requirement from the control circuit is minimal. In one embodiment each of the switching devices comprises a transistor coupled to an associated wound inductive component, the wound inductive components together defining a transformer.

Conveniently at least one of the switching elements, and preferably both of the switching elements , are MOSFETS. In other embodiments one or both of the switching elements may comprise a thyristor or bipolar transistor.

In one embodiment of the invention the drive and bridge circuit arrangement forms part of a circuit for igniting and supplying a gas discharge lamp, the circuit arrangement serving as a DC/AC converter providing AC signals to a load circuit incorporating the lamp and a suitable ballast circuit.

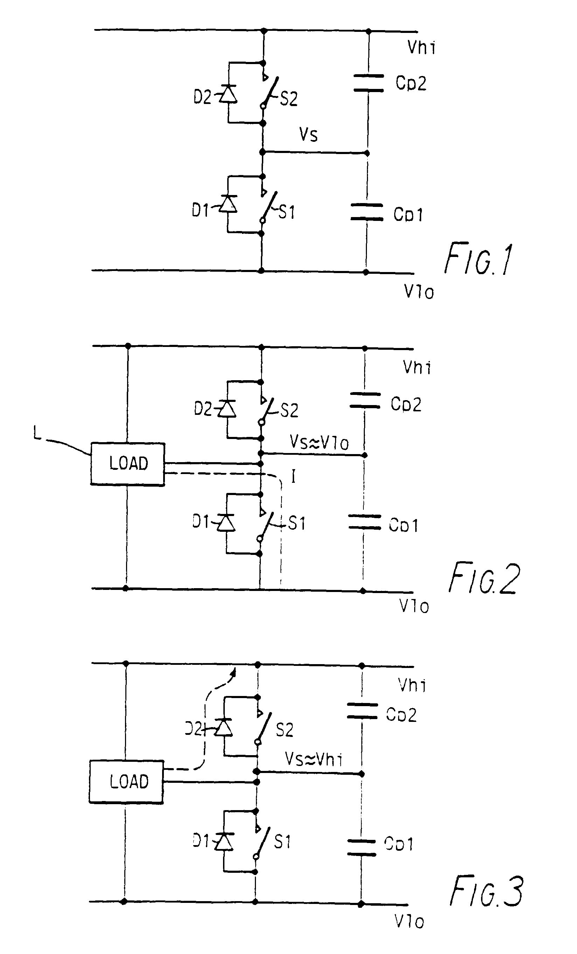

The present invention will be described further, by way of example, with reference to the accompanying drawings in which:-
- Figure 1:: illustrates a conventional half bridge switching circuit;
- Figures 2 and 3:: illustrate the half bridge switching circuit of Figure 1 coupled to an inductive load and showing respectively current flow during the closing and opening of switch S1;

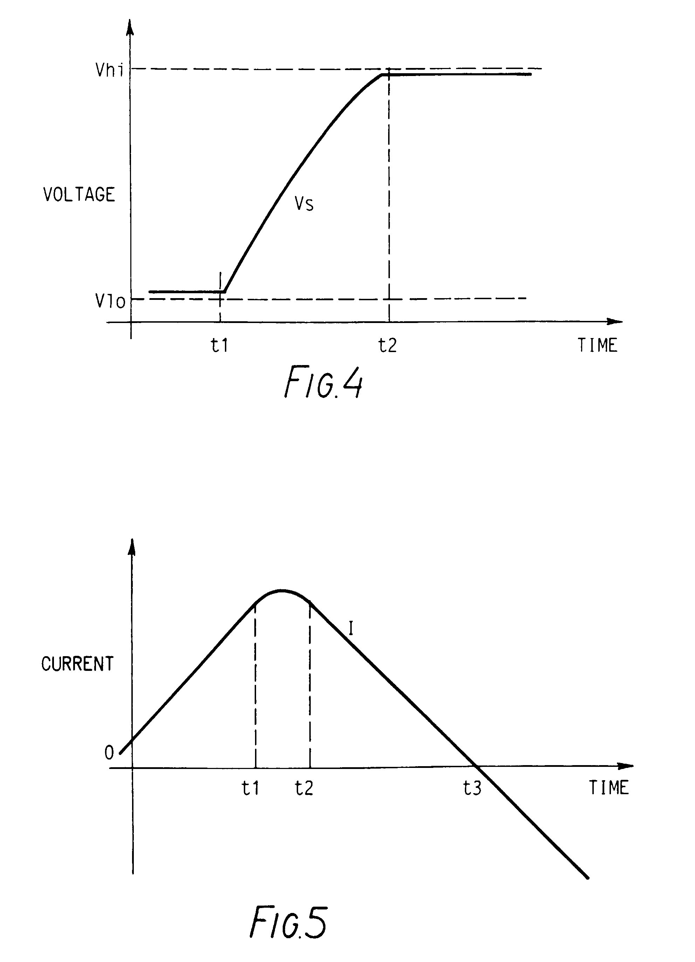

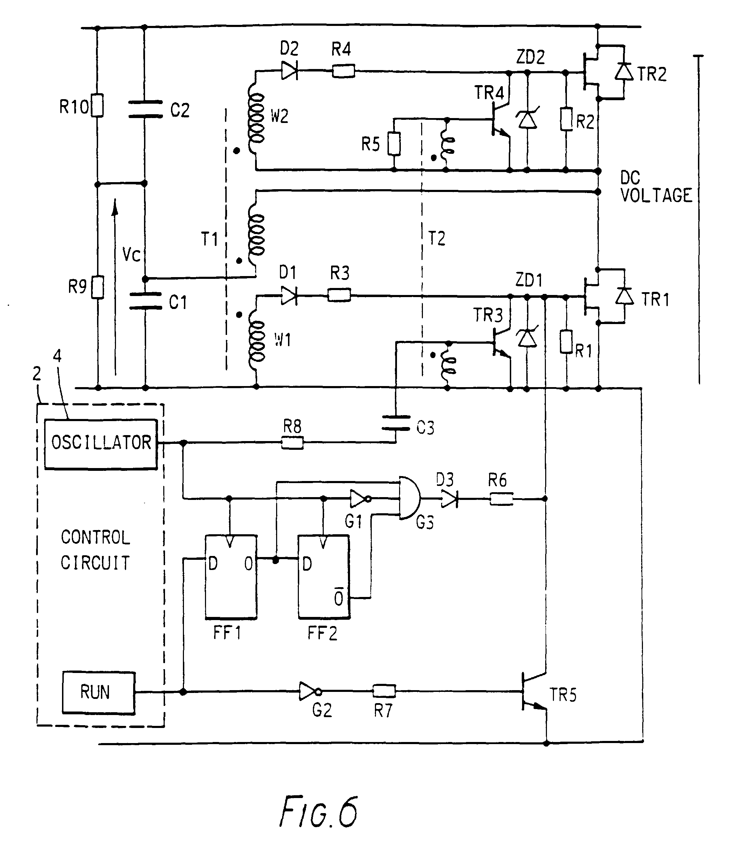

- Figures 4 and 5:: illustrate typical voltage and current changes associated with the circuits of Figures 2 and 3;
- Figure 6:: is a circuit diagram of a drive circuit in combination with a bridge circuit in accordance with one embodiment of the invention;

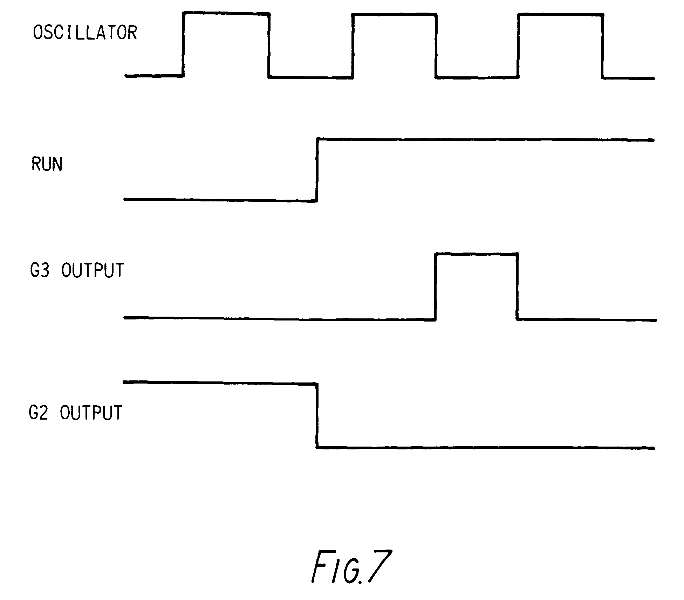

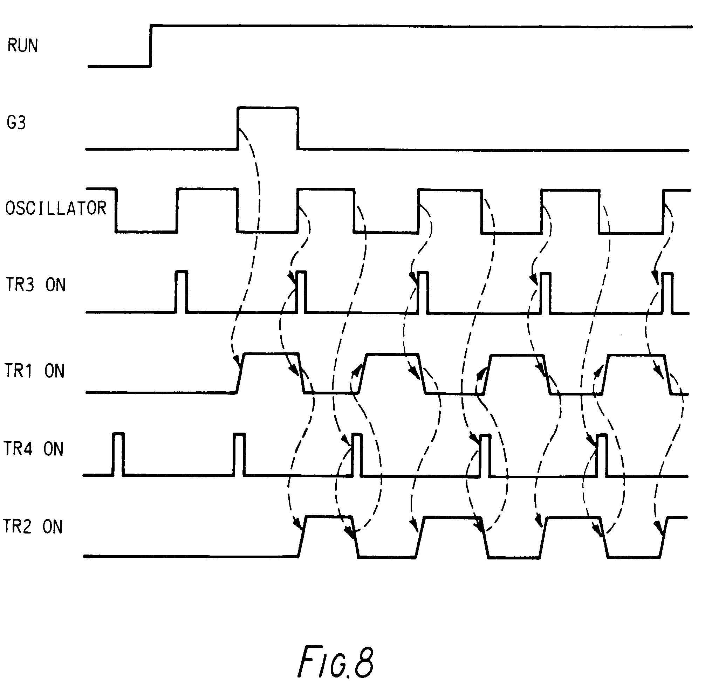

- Figures 7 and 8:: illustrate waveforms associated with the circuit of Figure 6.

By way of example the following description refers to Figure 6.

A DC voltage of 340 volts is applied across a series circuit of a pair of switching elements Tr1, Tr2 as shown in Figure 6. Tr1 and Tr2 are MOSFETS (type IRF830) and resistances R1 and R2 (150KΩ) prevent either MOSFET Tr1 or Tr2 being turned on due to the application of the DC supply which has a rise time of less than 3KV per ms.

A RUN signal (asserted to 7 volts and negated to 0 volts) is transmitted from a control circuit 2, the RUN signal being effective to stop and start the bridge inverter. The control circuit 2 implements a delay, in this embodiment 100ms, in order to ensure that resistances R9 and R10 (1MΩ) have charged the voltage Vc to approximately half of the DC voltage before the inverter is started. This ensures that sufficient stored capacitive energy is available with which to magnetise the primary inductance of a transformer T1 (type RM12) such that flyback commutation occurs as described below.

Following the assertion of the RUN signal a positive going pulse is issued by a gate G3 (a 3 input AND gate) this pulse being synchronised to a complete negative going half cycle of an oscillator 4. A transistor Tr5 (TYPE BCX38B) is turned off by the inversion of the RUN signal by a gate G2 (a logic invertor). These waveforms are illustrated in Figure 7.

Figure 8 illustrates more detail of the invertor operation as described below.

The pulse issued by the gate G3 turns on the MOSFET Tr1 placing a voltage across the transformer T1 and this voltage is transformed by windings W1 and W2 of the transformer T1.

The transformer T1 may be constructed from a RM12 core in N27 material, the primary winding having 90 turns and having isolated windings W1 and W2 of 7 turns closely coupled to the primary. W1 and W2 being phase connected as indicated by the dot notation on the circuit diagram and the core gapped so that the primary inductance is 2.5mH.

Current builds in the primary of the transformer T1 until the next positive going edge of the oscillator 4 which causes a pulse of charge to flow via a resistance R8 (1KΩ) and a capacitor C3 (100pF) energising the base of a transistor Tr3 (type BCX38B). A reverse voltage approximately equal to the base emitter voltage of the transistor Tr3 is placed across the base emitter of a transistor Tr4 (type BCX38B) by the anti-phase coupling of a transformer T2 (type EF12.6).

The transformer T2 may be constructed from an EF12.6 core in N27 material ungapped and a split bobbin used, each winding being 20 turns. Once again, the phase connection is as indicated by the dot natation on the circuit diagram.

The transistor Tr3 is turned on for a short period during which the gate of Tr1 is discharged and any positive voltage applied by W1 is dropped across a diode D1 and a resistance R3 (470Ω).

The MOSFET Tr1 turns off forcing the current flowing in the transformer T1 to flow by the reverse diode of the Tr2 MOSFET. This causes a reversal of the sense of the voltage across T1 generating a positive voltage from W2 sufficient to turn Tr2 on via a diode D2 and a resistance R4.

The maximum positive voltage applied to the gate-source of Tr2 is limited by the clamping action of a Zener diode ZD2 (a 10v Zener) with the resistance R4 (470Ω). The diode D2 (type IN4148) is included such that if the output voltage of W2 falls Tr2 is held on until being turned off by the transistor Tr4. The diode D2 also acts to prevent a negative voltage being placed across the transistor Tr4 and the Zener diode ZD2 when the output voltage of W2 is negative.

The current flowing in the primary of the transformer T1 is reduced to zero by the reverse DC voltage across it. Current then rises in the opposite direction in T1 flowing from the DC rail via Tr2. The negative transition of the oscillator 4 output causes a pulse of charge to flow via the resistance R8 and the capacitor C3 energising the base of the transistor Tr4 via the anti-phase coupling of the transformer T2. A reverse voltage approximately equal to the base emitter voltage of the transistor Tr4 is placed across the base emitter of the transistor Tr3 by the anti-phase coupling of the transformer T2.

The transistor Tr4 is turned on for a short period during which the gate of Tr2 is discharged and any positive voltage applied by W2 is dropped across the diode D2 and the resistance R4.

The MOSFET Tr2 turns off forcing the current flowing in the transformer T1 to flow by the reverse diode of the Tr1 MOSFET. This causes a reversal of the sense of the voltage across the transformer T1 generating a positive voltage from W1 sufficient to turn Tr1 on via the diode D1 and the resistance R3.

In this manner the inverter drive is established. Commutation follows every transition of the oscillator output.

D1 (type IN4148), R3 and ZD1 (a 10v Zener) perform the same functions on the Tr1 gate drive as do D2, R4 and ZD2 on the Tr2 gate drive.

A resistance R5 (1.5KΩ) is included to damp the reactive circuit formed by the capacitor C3 and the primary and leakage inductances of the transformer T2 such that only the transistor Tr3 is turned on following a positive oscillator transition and only the transistor Tr4 is turned on following a negative oscillator transition.

Whenever the RUN signal is negated the transistor Tr5 is turned on holding Tr1 off. The oscillator remains enabled sequentially turning on transistors Tr3 and Tr4 consequently turning off both Tr1 and Tr2 and halting the inverter. It may also be advantageous if the turn on of the transistor Tr5 is synchronised to a positive oscillator cycle such that Tr5 switches into the gate of Tr1 when it is already discharged.

On starting the inverter a pair of Flip Flops FF1 and FF2 (positive edge triggered D type flip flops) provide one oscillator half cycle in which the transistor Tr5 is turned off prior to the pulse being applied to Tr1 by G3.

Since the capacitor C3 is small the required control circuit drive current is low. For example if C3 is charged from 7 volts at an oscillator frequency of 50KHz the oscillator drive current consumption is approximately 35A.

It will be appreciated that the above embodiment of the invention provides independent turn on and turn off mechanisms as follows:-

### Turn Off

A secondary switching stage, which may take a variety of forms, is placed directly across the gate source connection of the MOSFET device. This second switching stage is activated by the control circuit 2, for example via the small pulse transformer T2.

The second switching stage may, for example, be as described above a darlington bipolar transistor. Alternatively a thyristor or small MOSFET may be employed.

The advantages gained from this mechanism are several fold. The gate discharge path can be a very low impedance with negligible leakage and parasitic inductances giving extremely good turn off performance. Since the activating signal can be very small, signal propagation delays are greatly reduced, the second switching stage also acting as a transition speed up device. Since the MOSFET control terminals are simply shorted out the only control circuit 2 drive current requirement apart from the pulse issued from gate G3 is to activate the second switching stage which is low due to the current gain of this stage.

### Turn On

This is a direct result of turn off commutation action. As was described earlier whenever a first switch is turned off the voltage at the switching point of that leg commutates automatically due to the inductive current that was flowing into the first switch. By connection of a wound inductive component such as transformer T2 to the switching point it is easy to generate an isolated winding which reflects the commutating voltage, this winding can be used to turn on the second switch in the bridge leg.

The advantage of this turn on mechanism is that it automatically synchronises with the turn off mechanism described and consumes no current from the control circuit.

The combination of turn on and turn off mechanisms as described in the above embodiment results in extremely low control circuit power consumption.

The low resistance, low inductance gate discharge path provides very good turn off performance with high switching efficiency.

The isolation barrier which is often a major cost component can be implemented using a small two winding split bobbin transformer at comparatively low cost to other bridge drive techniques.

Frequency and duty cycle are fully variable from the control circuit provided a net inductive load is maintained.

In the embodiment described, typical component types and values have been suggested for example only. The specified components should allow the circuit to be operated within the frequency range of 20KHz to 80KHz.

## Claims

1. A drive circuit in combination with a bridge circuit, said bridge circuit having a net load coupled to its output, the net load being inductive at the operating frequency, the combination of drive circuit and bridge circuit including a series circuit of first and second switching elements coupled between first and second DC voltage supply lines said switching elements having respective secondary feedback windings for the inductive load, and switching means for alternatively switching on and off said first and second switching elements, characterised in that said switching means comprises first and second switching devices each coupled to an associated one of said switching elements and synchronising means to energise the switching devices at predetermined intervals, the arrangement being such that energising the switching device associated with whichever switching element is ON switches that element OFF and that switching said switching element OFF causes, by virtue of the net load being inductive, a commutating voltage which is employed to turn ON said other switching element.

2. A drive circuit in combination with a bridge circuit according to claim 1 characterised in that at least one of said switching devices is connected directly across the switching control terminals of its associated switching element.

3. A drive circuit in combination with a bridge circuit according to claim 1 characterised in that at least one of said switching devices is a darlington bipolar transistor.

4. A drive circuit in combination with a bridge circuit according to claim 1 characterised in that at least one of said switching devices is a thyristor.

5. A drive circuit in combination with a bridge circuit according to claim 1 characterised in that at least one of said switching devices is a MOSFET.

6. A drive circuit in combination with a bridge circuit according to claim 1 characterised by circuit means whereby the energy used to turn on the switching elements is derived directly from the net load such that the total energy requirement from the control circuit is minimal.

7. A drive circuit in combination with a bridge circuit according to claim 1 characterised in that each of the switching devices comprises a transistor coupled to an associated component of said secondary feedback windings, the associated components together defining a transformer.

8. A drive circuit in combination with a bridge circuit according to claim 1 characterised in that at least one of the switching elements is MOSFET.

9. A drive circuit in combination with a bridge circuit according to claim 1 characterised in that at least one of the switching elements is a bipolar transistor.

10. A drive circuit in combination with a bridge circuit according to claim 1 characterised in that said net load includes an external load.

11. A drive circuit in combination with a bridge circuit according to claim 10 characterised in that said external load is a gas discharge lamp.

12. In combination a gas discharge lamp and circuit for igniting and supplying said lamp, said combination including a drive circuit in combination with a bridge circuit, said bridge circuit having a net load coupled to its output, the net load being inductive at the operating frequency, the combination of drive circuit and bridge circuit including a series circuit of first and second switching elements coupled between first and second DC voltage supply lines said switching elements having respective secondary feedback windings for the inductive load, and switching means for alternatively switching on and off said first and second switching elements, characterised in that said switching means comprises first and second switching devices each coupled to an associated one of said switching elements and synchronising means to energise the switching devices at predetermined intervals, the arrangement being such energising the switching device associated with whichever switching element is ON switches that element OFF and that switching said switching element OFF causes, by virtue of the net load being inductive, a commutation voltage which is employed to turn ON said other switching element.

## Patentansprüche

1. Ansteuerschaltung in Kombination mit einer Brückenschaltung, wobei die Brückenschaltung eine mit ihrem Ausgang verbundene Nutzlast aufweist, die bei der Betriebsfrequenz induktiv ist, wobei die Kombination der Ansteuerschaltung mit der Brückenschaltung eine Reihenschaltung aus einem ersten und einem zweiten Schaltelement enthält, die zwischen einer ersten und einer zweiten Gleichspannungs-Versorgungsleitung liegt, wobei die Schaltelemente entsprechende sekundäre Rückkopplungs-Wicklungen für die induktive Last haben, und wobei Schaltmittel vorgesehen sind, um abwechselnd das erste und zweite Schaltelement ein- und auszuschalten, dadurch gekennzeichnet daß die Schaltmittel erste und zweite Schaltvorrichtungen, die jeweils mit einem zugeordneten Schaltelement verbunden sind, und Synchronisationsmittel umfassen, um die Schaltvorrichtungen in vorgegebenen Intervallen zu erregen, wobei die Anordnung so ausgebildet ist, daß die Erregung der Schaltvorrichtung, die einem Schaltelement zugeordnet ist, das EIN ist, das Element auf AUS schaltet, und daß das Schalten des Schaltelements auf AUS, kraft der Nettolast induktiv zu sein, eine Kommutierungsspannung verursacht, die dazu verwendet wird, das andere Schaltelement auf EIN zu schalten.

2. Ansteuerschaltung in Kombination mit einer BrücKenschaltung nach Anspruch 1, dadurch gekennzeichnet, daß wenigstens eine der Schaltvorrichtungen unmittelbar mit den Schalt-Steueranschlüssen ihres zugeordneten Schaltelements verbunden ist.

3. Ansteuerschaltung in Kombination mit einer Brückenschaltung nach Anspruch 1, dadurch gekennzeichnet, daß wenigstens eine der Schaltvorrichtungen ein bipolarer Darlington-Transistor ist.

4. Ansteuerschaltung in Kombination mit einer Brückenschaltung nach Anspruch 1, dadurch gekennzeichnet, daß wenigstens eine der Schaltvorrichtungen ein Thyristor ist.

5. Ansteuerschaltung in Verbindung mit einer Brückenschaltung nach Anspruch 1, dadurch gekennzeichnet, daß wenigstens eine der Schaltvorrichtungen ein MOSFET ist.

6. Ansteuerschaltung in Kombination mit einer Brückenschaltung nach Anspruch 1, gekennzeichnet durch Schaltungsmittel, durch die die Energie, die zum Einschalten der Schaltelemente verwendet wird, unmittelbar von der Nutzlast derart abgeleitet wird, daß das Gesamt-Energieerfordernis von der Steuerschaltung minimal ist.

7. Ansteuerschaltung in Kombination mit einer Brückenschaltung nach Anspruch 1, dadurch gekennzeichnet, daß jede der Schaltvorrichtungen einen Transistor umfaßt, der mit einer zugeordneten Komponente der Sekundär-Rückkopplungswicklungen verbunden ist, wobei die zugeordneten Komponenten zusammen einen Transformator bilden.

8. Ansteuerschaltung in Kombination mit einer Brückenschaltung nach Anspruch 1, dadurch gekennzeichnet, daß wenigstens eines der Schaltelemente ein MOSFET ist.

9. Ansteuerschaltung in Kombination mit einer Brückenschaltung nach Anspruch 1, dadurch gekennzeichnet, daß wenigstens eines der Schaltelemente ein bipolarer Transistor ist.

10. Ansteuerschaltung in Kombination mit einer Brückenschaltung nach Anspruch 1, dadurch gekennzeichnet, daß die Nutzlast eine externe Last enthält.

11. Ansteuerschaltung in Kombination mit einer Brückenschaltung nach Anspruch 10, dadurch gekennzeichnet, daß die externe Last eine Gasentladungslampe ist.

12. Kombination einer Gasentladungslampe und einer Schaltung zur Zündung und Speisung der Lampe, wobei die Kombination eine Ansteuerschaltung in Kombination mit einer Brückenschaltung enthält, wobei die Brückenschaltung eine mit ihrem Ausgang verbundene Nutzlast hat, die bei der Betriebsfrequenz induktiv ist, wobei die Kombination der Ansteuerschaltung mit der Brückenschaltung eine Reihenschaltung aus einem ersten und einem zweiten Schaltelement enthält, die zwischen einer ersten und einer zweiten Gleichspannungs-Versorgungsleitung liegt, wobei die Schaltelemente entsprechende sekundäre Rückkopplungswicklungen für die induktive Last haben, und wobei Schaltmittel vorgesehen sind, um abwechselnd das erste und zweite Schaltelement ein- und auszuschalten, dadurch gekennzeichnet, daß die Schaltmittel erste und zweite Schaltvorrichtungen, die jeweils mit einem zugeordneten Schaltelement verbunden sind, und Synchronisationsmittel umfassen, um die Schaltvorrichtungen in vorgegebenen Intervallen zu erregen, wobei die Anordnung so ausgebildet ist, daß die Erregung der Schaltvorrichtung, die einem Schaltelement zugeordnet ist, das EIN ist, das Element auf AUS schaltet, und daß das Schalten des Schaltelements auf AUS, kraft der Nettolast induktiv zu sein, eine Kommutierungsspannung verursacht, die dazu verwendet wird, das andere Schaltelement auf EIN zu schalten.

## Revendications

1. Circuit de commande en association avec un circuit de pont, ledit circuit de pont ayant une charge nette couplée à sa sortie, la charge nette étant inductive à la fréquence de fonctionnement, l'association du circuit de commande et du circuit de pont comportant un circuit en série d'un premier et d'un deuxième éléments de commutation couplés entre une première et une deuxième lignes d'alimentation de tension en courant continu, lesdits éléments de commutation ayant des enroulements secondaires de contre-réaction respectifs pour la charge inductive, et des moyens de commutation pour alternativement commuter en position active et commuter en position non active lesdits premier et deuxième éléments de commutation, caractérisé en ce que lesdits moyens de commutation comprennent un premier et un deuxième dispositifs de commutation couplés chacun à un élément associé desdits éléments de commutation, et des moyens de synchronisation pour exciter les dispositifs de commutation à intervalles prédéterminés, l'agencement étant tel que l'excitation du dispositif de commutation associé à celui des éléments de commutation qui est ACTIF rend cet élément NON ACTIF, et que le fait de commuter cet élément de commutation en position NON ACTIVE provoque, en vertu du fait que la charge nette est inductive, une tension de commutation qui est utilisée pour rendre ACTIF ledit autre élément de commutation.

2. Circuit de commande en association avec un circuit de pont selon la revendication 1, caractérisé en ce que l'un au moins desdits dispositifs de commutation est directement connecté aux bornes de commande de commutation de son élément de commutation associé.

3. Circuit de commande en association avec un circuit de pont selon la revendication 1, caractérisé en ce que l'un au moins desdits dispositifs de commutation est un transistor bipolaire darlington.

4. Circuit de commande en association avec un circuit de pont selon la revendication 1, caractérisé en ce que l'un au moins desdits dispositifs de commutation est un thyristor.

5. Circuit de commande en association avec un circuit de pont selon la revendication 1, caractérisé en ce que l'un au moins desdits dispositifs de commutation est un MOSFET.

6. Circuit de commande en association avec un circuit de pont selon la revendication 1, caractérisé par des moyens de circuit tels que l'énergie utilisée pour rendre actifs les éléments de commutation est directement déduite de la charge nette, de façon que le besoin total en énergie du circuit de commande soit minimum.

7. Circuit de commande en association avec un circuit de pont selon la revendication 1, caractérisé en ce que chacun des dispositifs de commutation comprend un transistor couplé à un composant associé desdits enroulements secondaires de contre-réaction, les composants associés définissant ensemble un transformateur.

8. Circuit de commande en association avec un circuit de pont selon la revendication 1, caractérisé en ce que l'un au moins des éléments de commutation est un MOSFET.

9. Circuit de commande en association avec un circuit de pont selon la revendication 1, caractérisé en ce que l'un au moins des éléments de commutation est un transistor bipolaire.

10. Circuit de commande en association avec un circuit de pont selon la revendication 1, caractérisé en ce que ladite charge nette comporte une charge externe.

11. Circuit de commande en association avec un circuit de pont selon la revendication 10, caractérisé en ce que ladite charge externe est une lampe à décharge de gaz.

12. Lampe à décharge de gaz en association avec un circuit pour allumer et alimenter ladite lampe, ladite association comportant un circuit de commande en association avec un circuit de pont, ledit circuit de pont ayant une charge nette couplée à sa sortie, la charge nette étant inductive à la fréquence de fonctionnement, l'association du circuit de commande et du circuit de pont comportant un circuit en série d'un premier et d'un deuxième éléments de commutation couplés entre une première et une deuxième lignes d'alimentation de tension en courant continu, lesdits éléments de commutation ayant des enroulements secondaires de contre-réaction respectifs pour la charge inductive, et des moyens de commutation pour alternativement commuter en position active et commuter en position non active lesdits premier et deuxième éléments de commutation, caractérisé en ce que lesdits moyens de commutation comprennent un premier et un deuxième dispositifs de commutation couplés chacun à un élément associé desdits éléments de commutation, et des moyens de synchronisation pour exciter les dispositifs de commutation à intervalles prédéterminés, l'agencement étant tel que l'excitation du dispositif de commutation associé à celui des éléments de commutation qui est ACTIF rend cet élément NON ACTIF, et que le fait de commuter cet élément de commutation en position NON ACTIVE provoque, en vertu du fait que la charge nette est inductive, une tension de commutation qui est utilisée pour rendre ACTIF ledit autre élément de commutation.
